# DEMANDE DE BREVET EUROPEEN

(11) **EP 4 141 952 A1**
(43) Date de publication de la demande: **01.03.2023**
(21) Numéro de dépôt: 22191936.8
(22) Date de dépôt: 24.08.2022
(51) Int. Cl.: H01L 29/06, H01L 29/40, H01L 29/423, H01L 29/66, G06N 10/40, B82Y 10/00

(54) **DISPOSITIF QUANTIQUE INTÉGRANT UNE ELECTRODE ENTERRÉE METALLIQUE**

(30) Priorité: 31.08.2021 FR 2109068
(71) Demandeur: Commissariat à l'énergie atomique et aux énergies alternatives, 75015 Paris (FR)
(72) Inventeur: NIEBOJEWSKI, Heimanu, 38054 GRENOBLE CEDEX 09 (FR)
(74) Mandataire: Brevalex

(57) **Abrégé**

Réalisation d'un dispositif quantique à Qbits de spin, comportant :
- une première portion semi-conductrice (141) et une deuxième portion semi-conductrice (142) juxtaposée à la première portion semi-conductrice, lesdites portions semi-conductrices étant formées dans une couche superficielle d'un substrat de type semi-conducteur sur isolant et disposés sur une couche isolante (12) dudit substrat de type semi-conducteur sur isolant, le substrat étant muni d'une couche de support semi-conductrice (11) telle que ladite couche isolante (12) est agencée entre ladite couche de support (11) et ladite couche superficielle (141, 142),
- plusieurs paires (221, 222) de grilles de contrôle avant, chaque paire étant formée respectivement d'une première grille (221) de contrôle avant recouvrant une région de la première portion semi-conductrice (141) pour former un premier îlot quantique et d'une deuxième grille (222) de contrôle avant recouvrant une région de la deuxième portion semi-conductrice (142) formant un deuxième ilot quantique, une région isolante (160) étant prévue entre le premier îlot quantique et le deuxième îlot quantique de sorte à permettre un couplage électrostatique entre le premier îlot quantique et le deuxième îlot quantique,
le dispositif quantique étant doté d'une électrode conductrice arrière (150) disposée à l'aplomb de la région isolante (57a-57b-61) de couplage, ladite électrode conductrice arrière (150) étant formée d'une région d'alliage de matériau de matériaux métallique et semi-conducteur agencée dans ladite couche de support (11) semi-conductrice du substrat semi-conducteur sur isolant.

## Description

### DOMAINE TECHNIQUE

La présente demande concerne le domaine des dispositifs électroniques quantiques et en particulier celui de la réalisation d'un dispositif quantique à bits quantiques (également appelés quantum bits ou Qubits) formés d'ilots semi-conducteurs et utilisant, outre des électrodes de grille avant situées au-dessus des ilots, une électrode de contrôle arrière agencée en dessous du niveau dans lequel les ilots se situent.

### ÉTAT DE LA TECHNIQUE ANTÉRIEURE

Les îlots quantiques (parfois également appelées boîtes ou points quantiques) forment des éléments de base d'un dispositif électronique quantique. Les îlots quantiques sont typiquement formés dans une couche de matériau semi-conducteur dans laquelle des puits de potentiel sont mis en œuvre pour confiner des porteurs, électrons ou trous, dans les trois dimensions de l'espace. Une information quantique est alors codée par le biais du spin du porteur. On parle alors de Qubits de spin.

Selon une approche, des électrons sont confinés par effet de champ sous d'électrodes de grilles semblables à celles des structures de transistors et l'information est encodée dans le spin de ces électrons. Ces grilles dites « avant » sont disposées au-dessus de l'ensemble des ilots quantiques.

Pour certaines applications, un contrôle électrostatique arrière est utilisé afin de mieux moduler l'environnement électrostatique des ilots quantiques. Un tel contrôle est réalisé typiquement par le biais d'une électrode supplémentaire ainsi située au-dessous de l'ensemble des ilots quantiques.

Ce type de dispositif quantique fonctionne généralement à très basse température ce qui implique que si l'on souhaite réaliser la grille arrière en matériau semi-conducteur, celuici doit être très fortement dopé afin que la grille puisse rester conductrice et fonctionnelle.

Or, doper très fortement un substrat par implantation ionique pose le risque d'induire des dopants résiduels dans la couche semi-conductrice dans laquelle les ilots sont prévus. Cela n'est pas compatible avec un fonctionnement correct d'un dispositif quantique. Une autre méthode qui inclurait une étape de report de plaque avec une zone déjà dopée pour réaliser la grille arrière présenterait quant à elle l'inconvénient d'être complexe à mettre en œuvre et d'induire une variabilité de procédé importante.

Il en va de même pour une méthode qui consisterait à réaliser la grille arrière par structuration de la face arrière d'un substrat, par exemple en formant un via conducteur traversant la face arrière de ce substrat sur lequel les ilots sont prévus.

Par ailleurs, pour certaines applications, les dispositifs quantiques prévoient une ligne conductrice supplémentaire par laquelle on fait passer un signal RF afin de manipuler le spin d'électrons. Or, une telle ligne conductrice doit de préférence être située le plus proche possible des ilots semi-conducteurs. Il est ainsi connu de juxtaposer cette ligne à côté des ilots semi-conducteurs, ou de disposer une telle ligne au-dessus des ilots, par exemple dans un premier niveau de métal.

De tels agencements posent cependant un problème d'encombrement.

### EXPOSÉ DE L'INVENTION

Selon un aspect, la présente invention concerne un dispositif quantique à qubits de spin, comportant :
- une première portion semi-conductrice et une deuxième portion semi-conductrice juxtaposée à la première portion semi-conductrice, lesdites portions semi-conductrices étant formées dans une couche superficielle d'un substrat de type semi-conducteur sur isolant et disposés sur une couche isolante dudit substrat de type semi-conducteur sur isolant, le substrat étant muni d'une couche de support semi-conductrice telle que ladite couche isolante est agencée entre ladite couche de support et ladite couche superficielle,
- plusieurs paires de grilles de contrôle avant, chaque paire étant formée respectivement d'une première grille de contrôle avant recouvrant une région de la première portion semi-conductrice pour former un premier ilot quantique et d'une deuxième grille de contrôle avant recouvrant une région de la deuxième portion semi-conductrice formant un deuxième ilot quantique, une région isolante étant prévue, en particulier en termes de dimension et de composition, entre le premier ilot quantique et le deuxième ilot quantique et de sorte à permettre un couplage électrostatique entre le premier ilot quantique et le deuxième ilot quantique,
le dispositif quantique étant doté d'une électrode conductrice arrière disposée à l'aplomb de la région isolante, ladite électrode conductrice arrière étant formée d'une région à base de matériau métallique agencée dans ladite couche de support semi-conductrice du substrat semi-conducteur sur isolant.

Un tel agencement de l'électrode arrière permet de libérer de la place au-dessus de l'ensemble des ilots quantique afin notamment de pouvoir y intégrer d'éventuelles grilles de contrôles supplémentaires.

Un tel agencement de l'électrode de contrôle arrière est ici placée au plus proche de la zone active afin d'obtenir un couplage ESR optimisé.

Avantageusement, la région à base de matériau métallique peut être formée d'alliage de matériaux métallique et semi-conducteur

Avantageusement, la région métallique peut être également apte à adopter des propriétés supraconductrices. Un fonctionnement à très basse température, en particulier de l'ordre de plusieurs milliKelvins peut être ainsi prévu.

La région à base de matériau métallique peut être à base d'un des matériaux suivants : Ta, Pt, Nb, TiN, Co, V.

Selon une possibilité de mise en œuvre l'électrode conductrice arrière est configurée pour véhiculer un signal RF.

Selon une mise en œuvre particulière du dispositif, l'électrode conductrice arrière peut s'étend sous et en regard de la région isolante sans s'étendre en regard de l'une ou l'autre desdites première grille de contrôle et deuxième grille de contrôle.

Selon un autre aspect, la présente invention concerne un procédé de réalisation d'un dispositif tel que décrit précédemment.

Selon un autre aspect, la présente invention concerne un procédé de fabrication d'un dispositif quantique le procédé comprenant, dans cet ordre, des étapes consistant à :
- former sur une zone dite « zone active » d'une couche superficielle d'un substrat de type semi-conducteur sur isolant muni d'une couche de support semi-conductrice et d'une couche isolante agencée entre la couche de support et ladite couche superficielle, une pluralité de blocs de grilles,
- former une tranchée de séparation à travers lesdits blocs de grilles de sorte à partager chaque bloc de grille en une paire de grilles de contrôle avant, ladite tranchée de séparation étant réalisée s'étendant à travers la zone active de sorte à partager la zone active en une première portion semi-conductrice et une deuxième portion semi-conductrice, ladite tranchée s'étendant également à travers la couche isolante du substrat et ayant un fond dévoilant une zone de la couche de support,
- former au fond de la tranchée une électrode conductrice arrière.

Un tel procédé :
- permet un positionnement très précis de l'électrode de contrôle arrière,
- est moins invasif qu'un procédé face arrière, en particulier dans lequel on réalise une structuration de la face arrière d'un substrat ;
- permet d'éviter de doper très fortement le substrat pour réaliser l'électrode arrière,
- reste compatible avec l'intégration supplémentaire de grilles d'échange disposées au-dessus des ilots semi-conducteurs.

L'électrode conductrice arrière peut être en particulier formée par le biais d'étapes de :
- dépôt de métal sur ladite zone de la couche de support dévoilée au fond de la tranchée,
- traitement thermique de manière à former, un alliage entre ledit métal entre le matériau semi-conducteur de la zone de la couche de support.

Avantageusement, le procédé peut comprendre en outre, après formation des blocs de grille et préalablement à la réalisation de l'électrode de contrôle arrière :
- la formation d'une couche d'arrêt de gravure sur lesdits blocs de grille, la tranchée étant réalisée à travers ladite couche d'arrêt de gravure formée sur les blocs de grille.

Selon une possibilité de mise en œuvre, le procédé peut comprendre en outre, après formation des grilles et préalablement à la formation de la couche d'arrêt de gravure, des étapes de :
- croissance de matériau semi-conducteur dopé sur des régions de la zone active disposées de part et d'autre des blocs de grilles, de sorte à former des réservoirs de dopants,
- siliciuration d'une face supérieure desdits réservoirs et des blocs de grille.

Selon une possibilité de mise en œuvre du procédé dans lequel préalablement au dépôt de métal pour réaliser la région d'alliage de matériaux métallique et semi-conducteur, le procédé comprend des étapes de :
- formation de zones de protection diélectrique sur des flancs latéraux de la tranchée, les zones protection diélectrique étant agencées de sorte à s'étendre entre la première portion semi-conductrice et la deuxième portion semi-conductrice et à dévoiler la zone de la couche de support au fond de la tranchée.

Selon une possibilité de réalisation, après formation de l'électrode conductrice arrière, le procédé peut comprendre le remplissage de la tranchée par dépôt d'au moins une couche diélectrique, la couche diélectrique et les zones de protection diélectrique ayant une composition et un agencement prévus de manière à permettre d'établir un couplage électrostatique entre la première portion semi-conductrice et la deuxième portion semi-conductrice.

Selon une possibilité de mise en œuvre du procédé pour laquelle ladite tranchée réalisée s'étend dans une partie donnée du substrat située en périphérie de la zone active, et dans lequel après le dépôt de ladite au moins une couche diélectrique de remplissage, le procédé comprend : la réalisation de plots de contact dont au moins un plot de contact de ladite électrode de contrôle arrière, par :
- formation d'au moins un trou à travers la couche diélectrique, ledit trou débouchant dans ladite partie donnée dévoilant la couche de support,
- remplissage du trou à l'aide d'un matériau conducteur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Figure 1
Figure 2
Figure 3
Figure 4A
Figure 4B
Figure 4C
Figure 4D
Figure 5A
Figure 5B
Figure 5C
Figure 6
Figure 7
Figure 8
Figure 9
Figure 10A
Figure 10B
Figure 10C
Figure 11
Figure 12
Figure 13
Figure 14
Figure 15A
Figure 15B
Figure 16A
Figure 16B

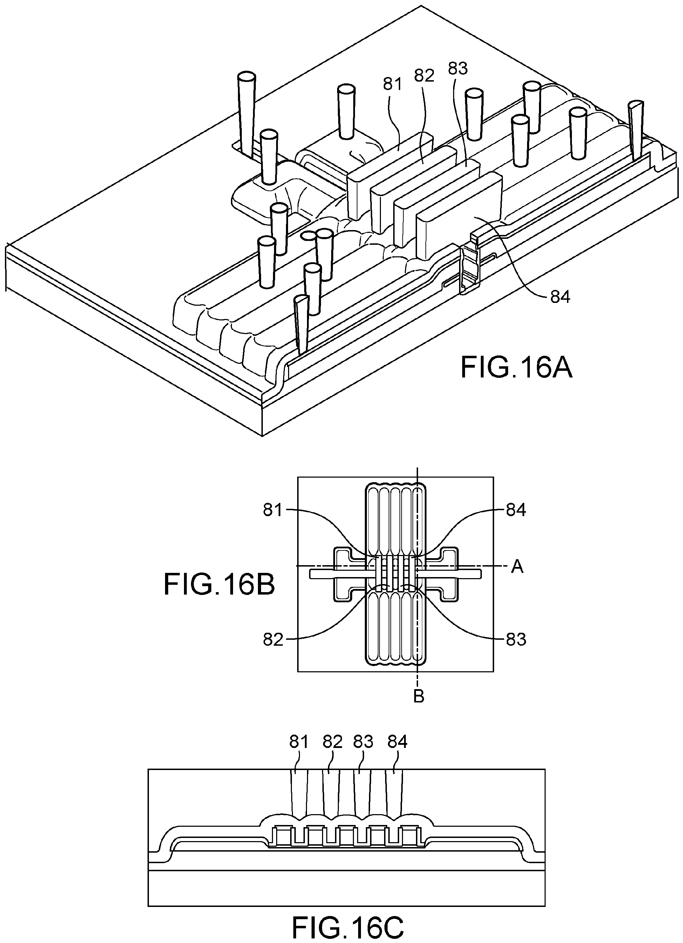

Figure 16C servent à illustrer un exemple de procédé de fabrication d'un dispositif quantique mis en œuvre suivant l'invention.
Figure 17

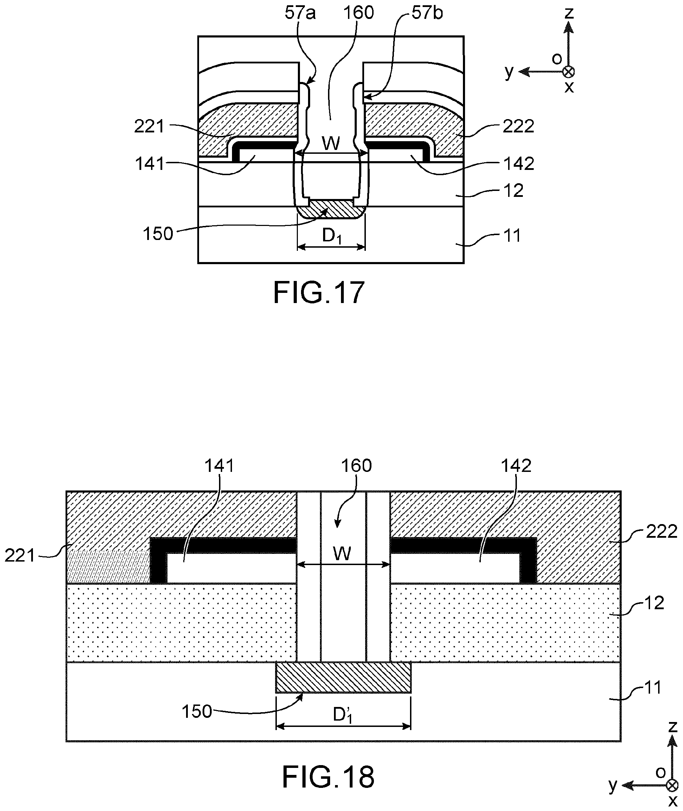

Figure 18 servent à illustrer un exemple de dispositif quantique mis en œuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « au-dessus », « au-dessous », « arrière », « avant », « périphérique » s'appliquent en considérant que la structure est orientée de la façon illustrée sur les figures.

### EXPOSÉ DÉTAILLÉ DE MODES DE RÉALISATION PARTICULIERS

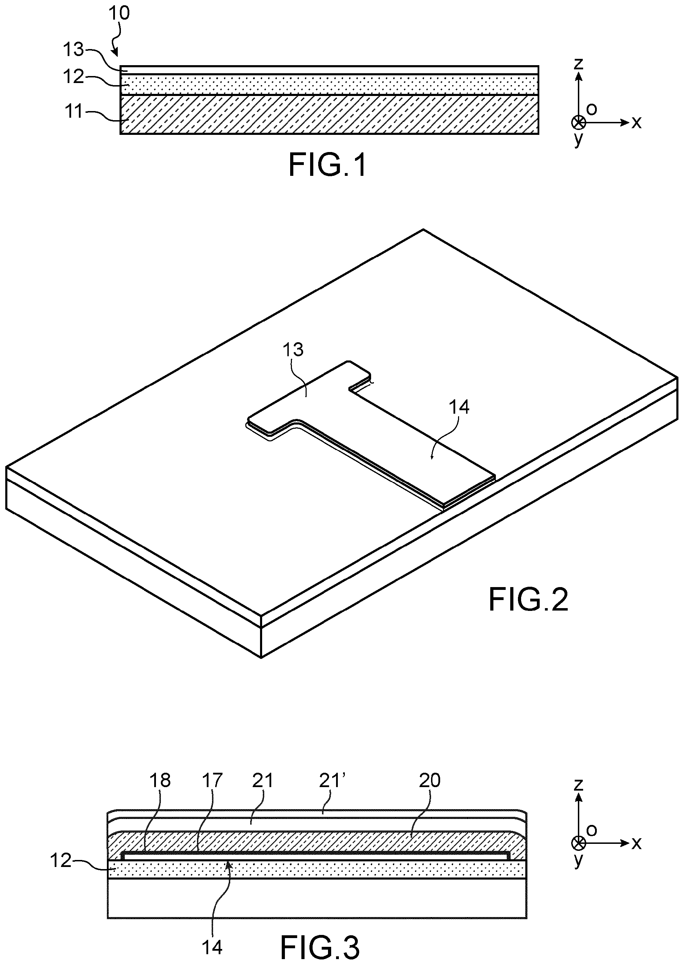

On se réfère tout d'abord à la figure 1 qui représente un matériau de départ possible pour la réalisation d'un dispositif quantique à qubits de spin et qui se trouve sous forme d'un substrat 10 de type semi-conducteur sur isolant.

Le substrat comporte ainsi une couche support 11 en matériau semi-conducteur, une couche isolante enterrée 12 disposée sur la couche support 11 et une couche superficielle 13 semi-conductrice disposée sur la couche isolante.

Le substrat est typiquement un substrat SOI dont la couche superficielle 13 est en silicium, en particulier du ²⁸Si lorsque cette couche est amenée à accueillir des qubits de spin d'électrons. D'autres matériaux semi-conducteurs peuvent être envisagés pour la couche semi-conductrice superficielle 13. En particulier, lorsque cette couche est amenée à accueillir des qubits de spin de trous, la couche superficielle peut être formée de Si₁₋ₓGeₓ avec x variant de préférence entre 0% à 70%.

Dans ce cas, la couche isolante 12 et la couche de support 11 sont typiquement, respectivement, une couche en oxyde de silicium communément appelée de « BOX » (pour « Burried Oxide » ou « oxyde enterré ») et une couche à base de silicium. L'épaisseur de la couche superficielle 13, est par exemple comprise entre environ 5 nm et 50 nm, typiquement de l'ordre de 10 nm. L'épaisseur de la couche isolante enterrée 12 est par exemple comprise entre 15nm et 150nm. Dans cette gamme on choisit de préférence une épaisseur proche de 15nm typiquement de l'ordre de 25nm, dans la mesure où cette couche est susceptible de devoir être gravée ultérieurement. L'épaisseur de la couche support 11 (les épaisseurs étant des dimensions mesurées selon l'axe z du repère orthogonal [O ;x ;y ;z] donné sur la figure 1) peut être quant à elle comprise par exemple de l'ordre de 775µm dans le cas où l'on utilise une plaque (« wafer » selon la terminologie anglo-saxonne) de type 300 mm.

Ensuite (figure 2), on peut définir dans la couche superficielle 13 au moins un motif de zone active 14. Cela peut être réalisé par photolithographie et gravure de la couche superficielle 13, en particulier une gravure plasma avec arrêt sur la couche isolante 12. Puis, on réalise un empilement de grille recouvrant la zone active 14. Cet empilement est typiquement formé (figure 3) d'une couche de diélectrique 17 de grille et d'une ou plusieurs couches 18, 20 de matériau(x) de grille semi-conducteur(s) tel que du polysilicium dopé et/ou métallique(s) tel que du TiN, de l'Al, ou du W.

Le diélectrique 17 de grille peut être un oxyde, en particulier un oxyde de silicium obtenu par dépôt ou par oxydation d'une épaisseur superficielle de la zone active 14. Par exemple, l'épaisseur de la couche de diélectrique 17 de grille peut être de l'ordre de 2 nm. Dans ce cas, selon un exemple de réalisation particulier, l'empilement de grille, peut, quant à lui, être formé d'une couche métal de TiN d'épaisseur par exemple de l'ordre de 6 nm et d'une couche de polysilicium par exemple de l'ordre de 30 nm.

L'empilement de grille peut être revêtu d'au moins une couche de masquage, en particulier d'une ou plusieurs couches 21, 21' de masque dur formées typiquement des couches isolantes, par exemple en SiN et/ou SiO₂. Dans l'exemple de réalisation illustré, un empilement est réalisé pour former ce masquage, en particulier un empilement bicouches, avec une couche 21 de SiN d'épaisseur comprise par exemple entre 20 nm et 30 nm revêtue d'une couche 21' d'oxyde de silicium d'épaisseur comprise par exemple entre 20 nm et 30 nm.

On définit ensuite par gravure une pluralité de blocs 24a, 24c, 24d, 24e de masquage afin de réaliser une pluralité de blocs de grilles 22a, 22b, 22c, 22d, 22e distincts. Des gravures anisotropes et en particulier à l'aide d'un plasma sont effectuées pour réaliser les blocs 24a, 24b, 24c, 24d, 24e de masquage, puis les de blocs de grilles 22a, ..., 22e distincts sous ces derniers et reproduisant les motifs de ces derniers.

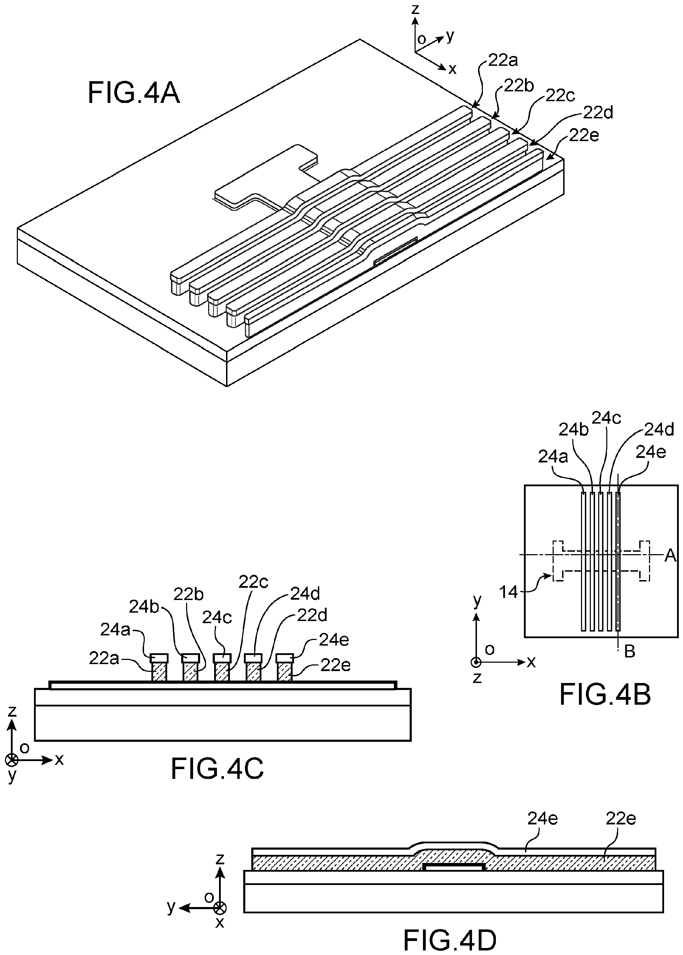

Une structure obtenue à l'issue de cette étape est illustrée sur les figues 4A, 4B, 4C, 4D donnant respectivement une vue en perspective, une vue de dessus, une vue en coupe transversale selon un axe longitudinal A qui s'étend dans le sens de la longueur de la zone active (dimension mesurée parallèlement à l'axe x du repère orthogonal [O ; x ; y ; z] sur la figure 4C), et une autre vue en coupe transversale selon un axe longitudinal B qui s'étend dans le sens de la largeur de la zone active (dimension mesurée parallèlement à l'axe y du repère orthogonal [O ; x ; y ; z] sur la figure 4D).

Les blocs de grilles 22a, ..., 22e ont dans cet exemple une forme de barreau parallélépipédique. Ces barreaux s'étendent typiquement dans une direction orthogonale à celle dans laquelle la zone active s'étend 14, autrement dit dans le sens de la largeur de la zone active 14. Les blocs 22a, ..., 22e de grille sont de préférence régulièrement espacés avec une répartition dense, par exemple telle que le pas de répartition est de l'ordre de 100 nm.

Des espaceurs isolants 23, 25 peuvent être ensuite formés de part et d'autre de chacun des blocs de grille. Les espaceurs 25, 25' peuvent être réalisés par dépôt d'une couche diélectrique 24, effectué de sorte à combler des espaces inter-grilles. Le matériau isolant des espaceurs est typiquement choisi parmi l'un des matériaux suivants : SiN, SiCO, SiBCN. Le procédé de dépôt est de préférence conforme, et en particulier de type ALD (pour « Atomic Layer Déposition » ou « dépôt de couche atomique ») afin de remplir les cavités inter-grilles sans création de défaut de remplissage. Selon un exemple de réalisation particulier, la couche diélectrique 24 déposée a une épaisseur de l'ordre de 30 nm.

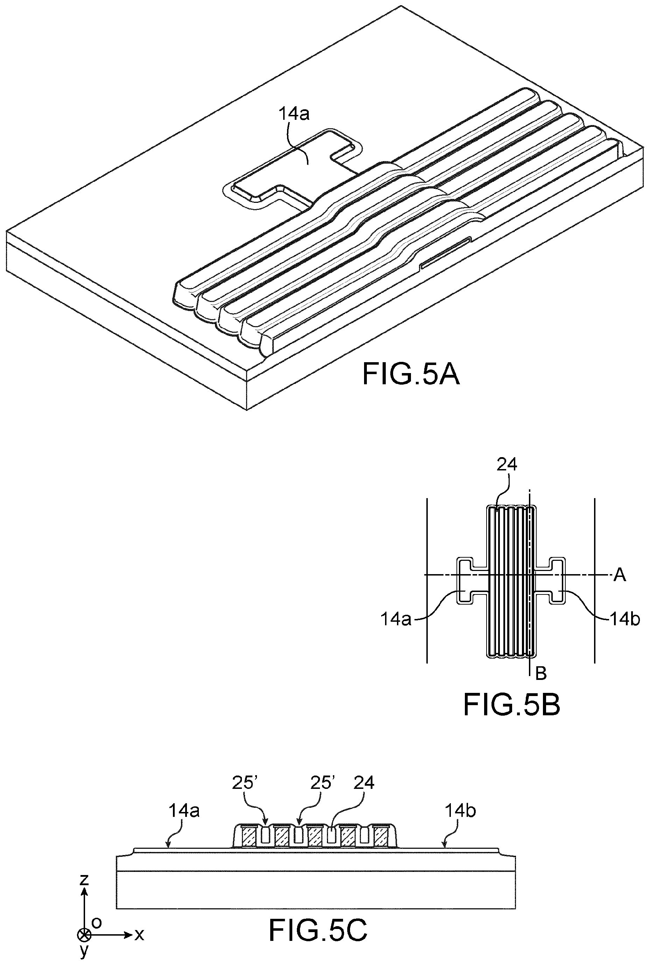

Dans l'exemple de réalisation illustré sur les figures 5A, 5B, 5C, (donnant respectivement une vue en perspective, une vue de dessus, une vue en coupe transversale selon un axe longitudinal A) on effectue ensuite une gravure de cette couche diélectrique 27 de sorte à retirer cette couche des régions 14a, 14b de la zone active.

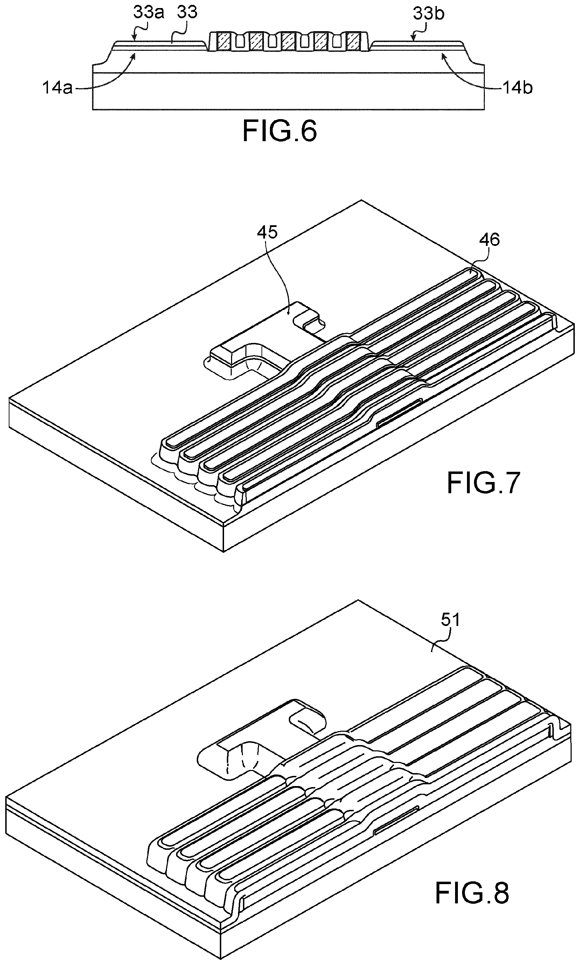

Pour compléter la formation de réservoirs 33a, 33b de dopants sur ces régions 14a, 14b et augmenter leur épaisseur on peut ensuite faire croitre une ou plusieurs couches de matériau(x) semi-conducteur(s) 33 sur les régions 14a, 14b dévoilées de la zone active (figure 6). On peut effectuer cela par croissance épitaxiale de silicium ou par le biais d'un dépôt CVD (pour « chemical vapor déposition », i.e. dépôt chimique en phase vapeur) par exemple de Germanium. Un dopage peut être alors réalisé par implantation ionique ou bien par dopage *in situ* effectué concomitamment à la croissance de la ou les couches de matériau(x) semi-conducteur(s) 33 par exemple pour former du Si:P (silicium dopé au phosphore) ou du SiGe:B (Silicium Germanium dopé au Bore).

Afin de diminuer la résistance de contact des réservoirs à dopants 33a, 33b et/ou des blocs 22a, ..., 22e de grille lorsqu'au moins une partie de ces blocs est réalisée en matériau semi-conducteur dopé, on peut ensuite former des zones à base de matériau métallique sur ces réservoirs et/ou blocs de grille.

Pour cela, on retire les blocs 24a, ..., 24e de masquage agencés sur les blocs de grille de manière à dévoiler la face supérieure de ces derniers.

Un tel retrait peut être réalisé au moyen d'un procédé de gravure chimique sélective. Par exemple, une gravure à l'aide de H₃PO₄ à une température de l'ordre de 100°C et pendant une durée d'une heure peut être mise en œuvre lorsque la portion de masquage retirée est en SiN. La durée de gravure peut être de l'ordre de 30 min, pour une couche de SiN de l'ordre de 20nm déposée par PECVD.

On peut ensuite former des régions d'alliage de métal et de semi-conducteur. Ainsi, dans l'exemple de réalisation illustré sur la figure 7, on forme de telles régions 45, 46 respectivement sur une face supérieure des blocs de grille ainsi que sur une face supérieure des réservoirs à dopants 33a, 33b.

Pour cela, un procédé de siliciuration comprenant une étape de dépôt d'au moins une couche de métal, tel que par exemple du Ni, du Pt, du W, du Co, du Ti, ou du V peut être effectué. La couche de métal peut être éventuellement recouverte d'une couche d'encapsulation qui peut être métallique. Un exemple d'encapsulation est formé par dépôt de TiN, d'épaisseur par exemple de l'ordre de 10 nm.

Un traitement thermique est effectué pour réaliser la siliciuration. Un tel traitement peut être mis en œuvre à une température comprise entre 200°C et 900°C et une durée adaptée en fonction de la température de traitement.

Un retrait du métal n'ayant pas réagi peut être ensuite effectué par exemple par gravure humide en utilisant une solution de type SPM (pour « Sulfuric Peroxide Mix » autrement dit mélange de péroxyde sulfurique) à chaud. Un deuxième recuit de siliciuration peut être également effectué.

Dans l'exemple de réalisation illustré sur la figure 7, des régions 45, 46 d'alliage de métal et de semi-conducteur, en particulier de siliciure sont ainsi formées respectivement sur les blocs grille et les réservoirs de dopants. Par exemple, l'épaisseur des régions 45, 46 siliciurées peut être de l'ordre de 15 nm.

Ce procédé a notamment pour particularité de prévoir une étape de découpe de la zone active 14 en portions séparées et disjointes après avoir formé les blocs de grille. Une telle découpe est typiquement réalisée par gravure à travers une ouverture pratiquée dans au moins un élément de masquage.

Ainsi, dans l'exemple illustré sur la figure 8, on forme tout d'abord une couche 51 d'arrêt de gravure.

Cette couche 51 d'arrêt peut être de type CESL (CESL pour « Contact Etch-Stop Layer » ou couche d'arrêt de gravure de contact), typiquement en nitrure de silicium ou en un matériau dérivé. La couche 51 d'arrêt de gravure peut être réalisée ici avec une épaisseur par exemple de l'ordre de 30 nm. Un procédé de dépôt de type PECVD (« Dépôt chimique en phase vapeur assisté par plasma ») peut être par exemple employé pour réaliser le dépôt d'une telle couche d'arrêt 51.

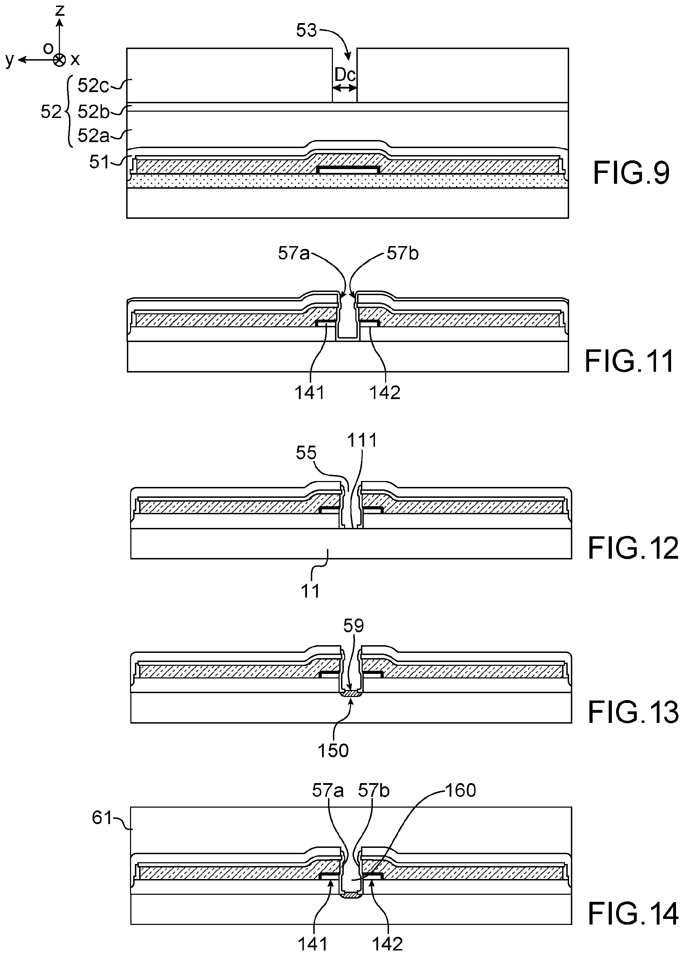

On forme ensuite un masque 52 doté d'une fente 53 qui s'étend principalement dans le sens de la longueur de la zone active (dimension mesurée parallèlement à l'axe x du repère [O ; x ; y ; z] donné sur la figure 9 et qui est parallèle à l'axe A de plan de coupe). La fente 53 s'étend en regard de la zone active 14 ainsi qu'en regard d'une région du substrat au-delà de la zone active 14 et dans laquelle la couche semi-conductrice superficielle a été retirée. Le masque 52 peut être formé de plusieurs couches empilées. Dans l'exemple de réalisation particulier illustré sur la figure 9, le masque 52 comporte un tri-couches, avec une première couche 52a formant un masque dur organique par exemple une couche de carbone déposée par centrifugation (« spin-on-carbone » ou SOC), surmontée d'une deuxième couche 52b anti-reflet, par exemple une couche antireflet au silicium (SiARC), et d'une troisième couche 52c qui peut être en particulier une couche de résine photosensible. A titre d'exemple, on peut prévoir une fente 53 dans le masque 52 de dimension critique Dc (plus petite dimension d'un motif hormis son épaisseur et qui est mesurée parallèlement au plan [O ; x ; y]) de l'ordre de 50 nm.

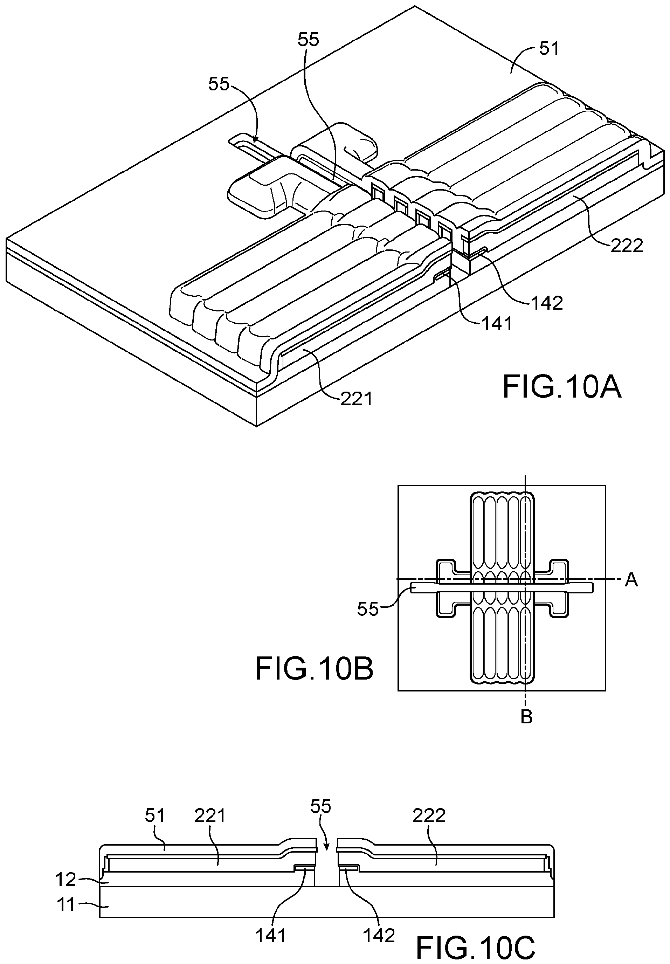

Puis, dans le prolongement de la fente 53, on forme une tranchée 55 afin de réaliser une découpe en deux parties des blocs de grille (figures 10A, 10B, 10C donnant respectivement une vue en perspective, une vue de dessus, une vue en coupe transversale parallèlement à l'axe B). La tranchée 55 reproduit typiquement le motif de la fente 53.

La division des blocs de grilles en deux partie permet la réalisation d'un premier ensemble de grilles 221 recouvrant la première portion semi-conductrice 141 et d'un deuxième ensemble de grilles 222 recouvrant la deuxième portion semi-conductrice 142, chacune des grilles du premier ensemble étant disposée en face et formant une paire avec une grille du deuxième ensemble.

Cette tranchée 55 est prolongée dans la zone active 14 afin de réaliser la découpe de cette zone active 14 en deux portions 141, 142. La tranchée 55 est réalisée de sorte à comporter un fond dévoilant la couche de support 11 du substrat semi-conducteur sur isolant. La tranchée 55 s'étend en regard de la zone active 14 et comporte une portion qui s'étend au-delà de la zone active 14 de sorte que cette partie de la tranchée 55 est formée à travers une région du substrat dans laquelle la couche semi-conductrice superficielle 13 est retirée.

La réalisation de la tranchée 55 peut être mise en œuvre au moyen de gravures anisotropes, typiquement à l'aide d'un plasma. On grave ainsi séquentiellement la couche d'arrêt 51, l'ensemble des matériaux formant l'empilement de grille, la zone active 14 prévue dans une partie de la couche superficielle 13 du substrat et la couche isolante 12 du substrat, typiquement de type BOX. La gravure s'arrête au niveau de la couche 11 de support du substrat semi-conducteur sur isolant, par exemple au niveau de la face supérieure de cette couche 11 de support semi-conductrice.

Une telle tranchée 55 permet d'accéder à la couche de support 11 afin de réaliser une électrode de contrôle arrière au niveau de cette dernière et en particulier au moins partiellement dans cette couche de support 11. Comme indiqué plus haut, une telle tranchée 55 permet également de séparer la zone active 14 en deux portions 141, 142 distinctes, une première portion 141 de la zone active 14 pouvant servir d'une région dans laquelle les Qubits sont localisés, tandis que la deuxième portion 142 de la zone active 14 pouvant former une région de détection de charge. La tranchée peut s'étendre dans une partie du substrat située en périphérie de la zone active 14 afin, en vue d'une réalisation ultérieure d'une prise de contact, de pouvoir accéder à la couche de support 10 dans une partie située hors de la zone active 14.

Selon un mode de réalisation particulier, préalablement à la formation d'une électrode de contrôle arrière par dépôt d'au moins une couche métallique dans la tranchée 153, on peut réaliser des zones de protection 57a, 57b contre des flancs latéraux de la tranchée 153 (figure 11). Les zones de protection 57a, 57b sont ainsi agencées de manière à recouvrir des régions des portions 141, 142 de la zone active 104 dévoilées par la réalisation de la tranchée 55. Les zones de protection 57a, 57b sont avantageusement en un matériau diélectrique tel que par exemple du SiN, du SiBCN, du SiO₂, du HfO₂, de l'Al₂O₃ ou du SiCO.

On peut choisir en particulier le matériau diélectrique de ces zones 57a, 57b ainsi que leur épaisseur en fonction d'un niveau de coupage électrostatique que l'on souhaite établir entre les deux portions 141, 142 séparées l'une de l'autre par la tranchée 55. Par exemple le matériau diélectrique déposé peut avoir une épaisseur comprise entre 5 et 15 nm.

Un dépôt de matériau de protection typiquement diélectrique est ainsi effectué de sorte à épouser les flancs de la tranchée 55. Ce matériau de protection est ensuite retiré par gravure anisotrope (figure 12), typiquement par le biais d'un plasma, afin de le retirer du fond de la tranchée 55. On dévoile ainsi à nouveau une zone 111 de la couche de support 11 semi-conductrice, au fond de la tranchée 55.

On forme ensuite l'électrode de contrôle arrière en effectuant tout d'abord un dépôt de matériau métallique. De manière préférentielle, l'électrode de contrôle arrière est réalisée par formation d'un alliage ou composé semi-conducteur et de métal au fond de la tranchée 55. Cela est réalisé typiquement par siliciuration, avec un procédé qui peut être semblable à celui décrit précédemment en lien avec la figure 7 afin de former des zones de contact sur les blocs de grille et les réservoirs de dopants.

Ainsi, une étape de dépôt d'au moins une couche en métal, tel que par exemple du Ni, du Pt, du W, du Co, du Ti, ou du V peut être tout d'abord effectuée. Un traitement thermique est ensuite réalisé. Un tel traitement peut être mis en œuvre à une température comprise entre 200°C et 900°C et une durée adaptée en fonction de la température de traitement. Par exemple, pour une température de l'ordre de 250°C on peut prévoir une durée de l'ordre de 30s

Un procédé de siliciuration sélectif peut être employé, de sorte que le siliciure ne se forme que là où le matériau semi-conducteur de la couche de support 11 est dévoilée ou mise à nu. L'épaisseur de la couche siliciurée peut être par exemple de l'ordre de 15 nm ou supérieure. Cette couche de siliciure 59 permet de former une grille arrière qui est métallique et n'est donc pas à base d'un matériau semi-conducteur dopé (figure 13).

Ensuite, on comble la tranchée 55 (figure 14) à l'aide d'un ou plusieurs matériaux diélectriques. Pour cela, on effectue un dépôt ou plusieurs dépôts successifs de matériau(x) diélectrique(s) suivi d'une planarisation CMP (en anglais « Chemical mechanical polishing » pour polissage mécano-chimique). Là encore, on peut choisir le ou les matériaux diélectriques de remplissage pour leur permittivité, en fonction d'un niveau de couplage électrostatique souhaité entre les deux portions 141, 142 de la zone active 14 qui sont disjointes et sont séparées l'une de l'autre par la tranchée 55. Par exemple, on effectue le remplissage avec un diélectrique 61 de type PMD (pour « premetal dielectric ») tel que de l'oxyde de silicium. Un remplissage conforme de la tranchée 55 peut être mis en œuvre par exemple en effectuant un dépôt FCVD (pour « Furnace Chemical Vapor Deposition », i.e. dépôt CVD au four) et un dépôt HDP (pour « High Density Plasma ») d'oxyde de silicium de type TEOS.

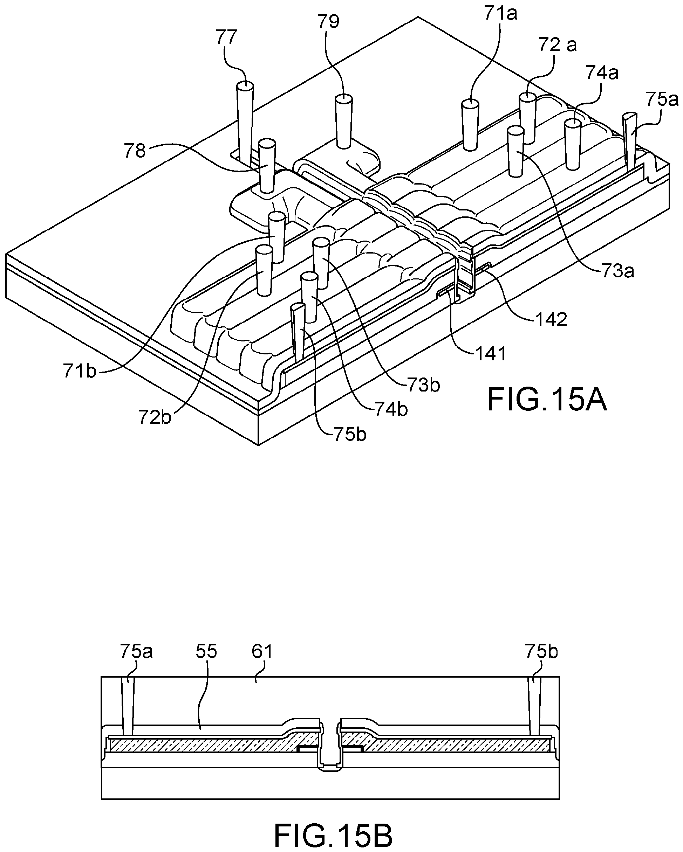

Puis (figures 15A et 15B donnant respectivement une vue en perspective et une en coupe transversale parallèle à l'axe B), on forme des plots de contact, avec en particuliers des plots de contact 71a, 72a, 73a, 74a, 75a sur des premiers blocs de grille qui sont situés d'un côté de la tranchée et recouvrent la première partie 141 de la zone active 14 et des plots de contact 71b, 72b, 73b, 74b, 75b sur des deuxièmes blocs de grille qui sont situés d'un autre côté de la tranchée 55, recouvrent la deuxième partie 142 de la zone active 103a et sont disjoints des premiers blocs de grille.

Des plots de contact 78, 79 sont également prévus sur les portions des réservoirs à dopants. De même, on prévoit typiquement au moins un plot 77 de contact sur l'électrode de contrôle arrière.

La réalisation des plots de contacts peut être effectuée par formation de trous traversant la couche diélectrique 61 et la couche 53 d'arrêt à la gravure, par exemple par photolithographie puis gravure plasma.

Un remplissage des trous à l'aide d'un métal tel que par exemple du W est ensuite effectué. Afin de rendre la figure 15A plus lisible, le matériau diélectrique 61 de remplissage de la tranchée et qui recouvre ici la structure n'est pas représenté.

Parmi ces trous, on prévoit typiquement de réaliser un trou traversant la tranchée 55 et débouchant dans une partie donnée dévoilant la couche de support. Une fois ce trou rempli de matériau conducteur, on forme ainsi un plot de contact pour une prise de contact sur l'électrode arrière 150.

Selon une possibilité de mise en œuvre (figures 16A, 16B, 16C), on peut compléter la réalisation de cette structure en formant des électrodes supplémentaires 81, 82, 83, 84 dites grilles d'échange qui s'étendent au-dessus des portions semi-conductrices 141, 142, dans une direction parallèle à celle des blocs. Ces électrodes permettent de moduler les barrières de potentiel entre deux ilots quantiques successifs. Elles modulent donc le couplage entre les ilots et permettent ainsi de réaliser un contrôle de l'énergie d'échange des ilots quantiques. Afin de rendre la figure 16A plus lisible, le matériau diélectrique 161 de remplissage de la tranchée et qui recouvre ici la structure n'est, là encore, pas représenté.

Sur la figure 17, une vue en coupe d'un dispositif quantique à qubits de spin, et qui peut avoir été réalisé à l'aide d'un procédé tel que décrit précédemment est donnée.

Le dispositif comporte une première portion semi-conductrice 141 dans laquelle une rangée d'ilots quantiques est prévue et une deuxième portion semi-conductrice 142, juxtaposée à la première portion semi-conductrice, et dans laquelle une autre rangée d'ilots quantiques est réalisée. Les portions semi-conductrices 141, 142 présentent des blocs de forme oblongue par exemple parallélépipédique dans lesquelles des ilots quantiques sont agencés et séparés deux à deux par une barrière tunnel. Aux extrémités de ces blocs des réservoirs de dopants sont typiquement prévus. Sur la vue en coupe de la figure 17 seuls les blocs qui s'étendent dans une direction orthogonale au plan de la figure sont représentés.

Les ilots de la première portion 141 sont prévus pour former une première rangée de qubits de donnée, tandis que les ilots de la deuxième portion 142 forment une deuxième rangée d'éléments de détection pour la lecture de valeur codée des qubits de donnée de la première rangée.

Au-dessus de chaque ilot de la première rangée, une grille 221 de contrôle avant est agencée, et face à cette grille 221, au-dessus de chaque ilot de la deuxième rangée d'ilots de détection, une grille 222 de contrôle est prévue.

Les portions semi-conductrices 141, 142 sont séparées l'une de l'autre par l'intermédiaire d'une région isolante 160. La constante diélectrique de cette région 160 qui dépend de sa composition en matériau(x) diélectrique(s) et son dimensionnement, en particulier la largeur W (dimension mesurée parallèlement à l'axe y du repère orthogonal [O ;x ;y ;z]) entre les portions 141,142, sont prévus entre le premier ilot quantique 141 et le deuxième ilot quantique 142 de sorte à permettre un couplage électrostatique entre ces ilots 141, 142. Le couplage est tel que courant dans le détecteur de charge est susceptible de varier typiquement d'un facteur de 10 en fonction du taux d'occupation de l'ilot quantique.

Dans l'exemple de réalisation illustré, la région isolante 160 est composée de zones diélectriques 57a, 57b disposées respectivement contre la première portion semi-conductrice 141 et contre la deuxième portion semi-conductrice 142 et à base d'un matériau diélectrique de constante diélectrique k₁, par exemple du nitrure de silicium et d'une couche diélectrique 60 entre ces zones 57a, 57b. La couche diélectrique 60 est composée d'un matériau différent de celui des zones 57a, 57b, par exemple de l'oxyde de silicium et de constante diélectrique k₂ tel que k₂ ≠ k₁. Il est en variante possible de prévoir une région 160 isolante en un seul matériau diélectrique ou composée de plus de deux matériaux diélectriques distincts. Afin de limiter une non-uniformité de potentiel au sein des portions semi-conductrices 141, 142, on prévoit avantageusement un ou des matériaux de faible permittivité pour former la région isolante 160. Les matériaux diélectriques utilisés pour former la région isolante 160 sont choisis de par leurs constantes diélectriques respectives en fonction du niveau de couplage souhaité.

Sous et en regard de la région isolante 160 autrement dit à l'aplomb de cette région 160, le dispositif est doté d'une électrode conductrice 150 supplémentaire et qui est à base d'un matériau métallique, en particulier d'un alliage de métal et de semi-conducteur tel que du CoSi₂ ou du V₃Si. Cette électrode 150 métallique est ainsi avantageusement en un matériau susceptible de former un supraconducteur et fonctionner à des températures très basses, en particulier de l'ordre de plusieurs milliKelvins.

Pour une distance séparant les portions semi-conductrices 141, 142 par exemple comprise entre 40 et 50nm, on peut considérer une permittivité relative effective du ou des matériaux qui sépare(nt) ces deux zones semi-conductrices typiquement supérieure à 3.

L'électrode 150 s'étend typiquement dans une direction orthogonale à celle de la direction principale des paires 221, 222 de grilles, autrement dit dans le sens de la longueur des portions semi-conductrices 141, 142. Une telle électrode 150 également appelée « grille arrière » participe au contrôle des états respectifs de spin des ilots formant des Qubits par couplage RPE (pour « Résonance Paramagnétique Electronique », également appelé ESR pour « Electron Spin Resonance » selon la terminologie anglo-saxonne, i.e. résonance de spin électronique). Cette électrode 150 est adaptée, de par sa composition et ses dimensions, à véhiculer un signal RF, par exemple de l'ordre de plusieurs GHz, afin de générer un champ magnétique oscillant. L'électrode 150 étant dans cet exemple réalisée sous la couche isolante 12 d'un substrat semi-conducteur sur isolant elle est agencée au plus près des portions semi-conductrices 141, 142. Cela participe à l'obtention d'un meilleur couplage.

On utilise avantageusement une couche isolante 12, typiquement de type oxyde enterré épaisse, afin de réduire les risques de non uniformité de potentiel dans les portions semi-conductrices. La couche isolante 12 peut être par exemple une couche de BOX d'épaisseur de 25 nm.

Dans l'exemple illustré sur la figure 17, l'électrode 150 enterrée a une largeur D1 (dimension mesurée parallèlement à l'axe y du repère orthogonal [O ;x ;y ;z]) qui correspond sensiblement à celle de la région isolante 160 entre les portions semi-conductrices 141, 142. Ainsi, dans l'exemple de réalisation illustré sur la figure 17, l'électrode 150 enterrée est située à l'aplomb de la région 160 située dans un espace entre paires 221, 222 de grilles sans s'étendre en regard de l'un ou l'autre de ces paires de grilles.

On peut prévoir en variante comme sur l'agencement de la figure 18, une électrode 150 arrière plus large de sorte à s'étendre au moins partiellement sous les portions semi-conductrices 141, 142 sans que cela n'impacte significativement la fonctionnalité du dispositif ou de la grille arrière.

## Revendications

1. Dispositif quantique à Qubits de spin, comportant :
- une première portion semi-conductrice (141) et une deuxième portion semi-conductrice (142) juxtaposée à la première portion semi-conductrice, lesdites portions semi-conductrices étant formées dans une couche superficielle (13) d'un substrat de type semi-conducteur sur isolant et disposés sur une couche isolante (12) dudit substrat de type semi-conducteur sur isolant, le substrat étant muni d'une couche (11) de support semi-conductrice telle que ladite couche isolante (12) est agencée entre ladite couche de support et ladite couche superficielle,
- plusieurs paires (221, 222) de grilles de contrôle avant, chaque paire étant formée respectivement d'une première grille (221) de contrôle avant recouvrant une région de la première portion semi-conductrice (141) pour former un premier ilot quantique et d'une deuxième grille (222) de contrôle avant recouvrant une région de la deuxième portion semi-conductrice (142) formant un deuxième ilot quantique, une région isolante (160, 57a-57b-61) étant présente entre le premier ilot quantique et le deuxième ilot quantique et formée d'un ou plusieurs matériaux diélectriques, la région isolante (160, 57a-57b-61) étant configurée de sorte à autoriser un couplage électrostatique entre le premier ilot quantique et le deuxième ilot quantique,
le dispositif quantique étant doté d'une électrode conductrice arrière (150) disposée à l'aplomb de la région isolante (160, 57a-57b-61) ladite électrode conductrice arrière (150) étant formée d'une région (59) à base de matériau métallique agencée dans ladite couche de support (11) semi-conductrice du substrat semi-conducteur sur isolant.

2. Dispositif selon la revendication 1, dans lequel la région à base de matériau métallique est formée d'alliage de matériaux métallique et semi-conducteur.

3. Dispositif selon l'une des revendications 1 ou 2, dans lequel la région à base de matériau métallique est à base d'un des matériaux suivants : Ta, Pt, Nb, TiN, Co, V.

4. Dispositif selon l'une des revendications 1 à 3, dans lequel la région isolante (160) est composée de matériaux diélectriques différents.

5. Dispositif selon l'une des revendications 1 à 4, dans lequel l'électrode conductrice arrière (150) s'étend sous et en regard de la région isolante (160) sans s'étendre en regard de l'une ou l'autre desdites première grille (221) de contrôle et deuxième grille (222) de contrôle.

6. Procédé de fabrication d'un dispositif quantique à Qubits de spin selon la revendication 1, le procédé comprenant, dans cet ordre, des étapes consistant à :
- former sur une zone (14) dite « zone active » d'une couche superficielle (13) d'un substrat de type semi-conducteur sur isolant muni d'une couche (11) de support semi-conductrice et d'une couche isolante (12) agencée entre la couche de support (11) et ladite couche superficielle (13), une pluralité de blocs (22a,...,22e) de grilles,
- former une tranchée (55) de séparation à travers lesdits blocs de grilles de sorte à partager chaque bloc de grille en une paire (221, 222) de grilles de contrôle avant, ladite tranchée (55) de séparation s'étendant à travers la zone active (14) de sorte à partager la zone active (14) en une première portion semi-conductrice (141) et une deuxième portion semi-conductrice (142), ladite tranchée (55) s'étendant également à travers la couche isolante (12) du substrat et ayant un fond dévoilant une zone (111) de la couche (11) de support,
- former au fond de la tranchée (55) une électrode conductrice (150) arrière.

7. Procédé selon la revendication 6, dans lequel l'électrode conductrice arrière (150) est formée par le biais d'étapes de :
- dépôt de métal sur ladite zone (111) de la couche de support dévoilée au fond de la tranchée (55),
- traitement thermique de manière à former, un alliage entre ledit métal entre le matériau semi-conducteur de la zone (111) de la couche (11) de support.

8. Procédé selon l'une des revendications 6 ou 7, comprenant en outre, après formation des blocs (22a,...,22e) de grille et préalablement à la réalisation de l'électrode (150) de contrôle arrière :
- la formation d'une couche (51) d'arrêt de gravure sur lesdits blocs (22a,...,22e) de grille, la tranchée (55) étant réalisée à travers ladite couche (51) d'arrêt de gravure formée sur les blocs de grille.

9. Procédé selon la revendication 8, comprenant en outre, après formation des grilles et préalablement à la formation de la couche d'arrêt de gravure, des étapes de :
- croissance de matériau semi-conducteur dopé (33) sur des régions (14a, 14b) de la zone active (14) disposées de part et d'autre des blocs de grilles (22a,...,22e), de sorte à former des réservoirs de dopants,
- siliciuration d'une face supérieure desdits réservoirs et des blocs (22a,...,22e) de grille.

10. Procédé selon l'une des revendications 6 à 8, dans lequel préalablement au dépôt de métal, le procédé comprend des étapes de :
- formation de zones (57a, 57b) de protection diélectrique sur des flancs latéraux de la tranchée (55), les zones (57a, 57b) de protection diélectrique étant agencées de sorte à s'étendre entre la première portion semi-conductrice (141) et la deuxième portion semi-conductrice (142) et à dévoiler la zone (111) de la couche de support au fond de la tranchée (55).

11. Procédé selon la revendication 10, dans lequel, après formation de l'électrode conductrice (150) arrière, le procédé comprend le remplissage de la tranchée (55) par dépôt d'au moins une couche diélectrique (61), la couche diélectrique (61) et les zones (57a, 57b) de protection diélectrique ayant une composition et un agencement prévus de manière à permettre d'établir un couplage électrostatique entre la première portion semi-conductrice (141) et la deuxième portion semi-conductrice (142).

12. Procédé selon la revendication 11, dans lequel ladite tranchée (55) réalisée s'étend dans une partie donnée du substrat située en périphérie de la zone active (14), et dans lequel après le dépôt de ladite au moins une couche diélectrique (61) de remplissage, le procédé comprenant en outre: la réalisation de plots de contact (77, 78, 79, 71a, 72a, 73a, 74a, 75a, 71b, 72b, 73b, 74b, 75b) dont au moins un plot de contact (77) de ladite électrode (150) de contrôle arrière, par :
- formation d'au moins un trou à travers la couche diélectrique (61), ledit trou débouchant dans ladite partie donnée dévoilant la couche de support,
- remplissage du trou à l'aide d'un matériau conducteur.
